# EUROPÄISCHE PATENTANMELDUNG

(11) **EP 1 067 332 A2**
(43) Veröffentlichungstag der Anmeldung: **10.01.2001**
(21) Anmeldenummer: 00114364.3
(22) Anmeldetag: 05.07.2000
(51) Int. Cl.: F21V 29/00

(54) **Fahrzeugleuchte**

(30) Priorität: 09.07.1999 DE 19932051
(71) Anmelder: Hella KG Hueck & Co., 59552 Lippstadt (DE)
(72) Erfinder: Nachtigall, Klaus, Dipl.-Ing., 79199 Kirchzarten (DE); Zwick, Huber, Dipl.-Phys., 70173 Stuttgart (DE)
(74) Vertreter: Schmitt, Hans, Dipl.-Ing.

(57) **Zusammenfassung**

Eine insbesondere als Signalleuchte ausgebildete Fahrzeugleuchte 1 weist als Lichtquelle wenigstens eine Leuchtdiode 2 auf, die mit einer Wärmeableiteinrichtung thermisch leitend verbunden ist. Zur Kühlung der Leuchtdiode(n) (2) ist die Wärmeableiteinrichtung als aktive Temperiereinrichtung ausgebildet.

## Beschreibung

Die Erfindung betrifft eine Fahrzeugleuchte, insbesondere eine Signalleuchte, mit wenigstens einer Leuchtdiode als Lichtquelle, die mit einer Wärmeableitabrichtung thermisch leitend verbunden

Eine derartige Fahrzeugleuchte ist aus EP 0 202 335 B1 bekannt. Sie weist eine Leiterplatte auf, auf deren Vorderseite eine Matrix mit einer Vielzahl von in mehreren Reihen und Spalten gruppierten Leuchtdioden angeordnet ist. An der Rückseite der Leiterplatte ist als Wärmeableiteinrichtung ein Lamellenkühlkörper angeordnet, der mit der Rückseite der Leiterplatte über einen wärmeleitenden Absorber verbunden ist. Der Lamellenkühlkörper ermöglicht zwar eine gewisse Absenkung der Betriebstemperatur der auf der Leiterplatte befindlichen Leuchtdioden, hat jedoch den Nachteil, daß die über den Kühlkörper abgeführte Wärmeleistung von der Umgebungstemperatur abhängig ist und mit zunehmender Umgebungstemperatur abnimmt. Insbesondere bei den bei Fahrzeugleuchten auftretenden hohen Betriebstemperaturen von bis zu 90° Celsius ist deshalb eine effektive Kühlung der Leuchtdioden praktisch nicht mehr möglich. Um dennoch auch bei diesen hohen Temperaturen einen Dauerbetrieb der Fahrzeugleuchte zu ermöglichen, müssen die Leuchtdioden mit einem entsprechend geringen Betriebsstrom bestromt werden, so daß die an den Leuchtdioden auftretende Verlustleistung entsprechend gering ist. Da die Lichtstärke der Leuchtdioden etwa proportional zu deren Betriebsstrom ist, ergibt sich bei Reduzierung des Betriebsstroms jedoch auch eine entsprechend geringe Lichtabgabe. So muß beispielsweise bei einer Betriebstemperatur von 80 °C der Betriebsstrom der Leuchtdioden gegenüber einer Betriebstemperatur von etwa 25 °C auf etwa die Hälfte abgesenkt werden, wodurch sich die von den Leuchtdioden abgegebene Lichtstärke ebenfalls etwa auf die Hälfte reduziert. Darüberhinaus haben Leuchtdioden aber auch noch einen negativen Temperaturkoeffizienten, d.h. ihre Lichtstärke nimmt mit zunehmender Betriebs- bzw. Sperrschichttemperatur ab. Damit die Fahrzeugleuchte auch bei hohen Umgebungstemperaturen eine geforderte Lichtstärke erreichen kann, muß deshalb die Anzahl der Leuchtdioden entsprechend groß gewählt werden. Die Fahrzeugleuchte ist deshalb noch vergleichsweise teuer.

Aus DE 197 28 763 A1 ist auch bereits eine Fahrzeugleuchte bekannt, bei der den Leuchtdioden ein PTC-Widerstand (Kaltleiter) vorgeschaltet ist, mittels dem der Betriebsstrom der Leuchtdioden bei hohen Umgebungstemperaturen abgesenkt wird. Dadurch kann zwar bei mittleren und geringen Umgebungstemperaturen eine größere Lichtstärke erreicht werden, jedoch nimmt die Lichtstärke bei höheren Umgebungstemperaturen etwa proportional zur Absenkung des Betriebsstroms der Leuchtdioden ab. Nachteilig ist außerdem, daß sich beim Verändern des Betriebsstroms der Leuchtdiode auch deren Leuchtfarbe ändert, was besonders bei Signalleuchten problematisch ist, bei denen die Wellenlänge des ausgesendeten Lichts aufgrund gesetzlicher Bestimmungen in einem fest vorgegebenen Spektralbereich liegen muß. Ungünstig ist außerdem, daß die in dem PTC-Widerstand umgesetzte Verlustleistung ebenfalls zur Erwärmung der Fahrzeugleuchte beiträgt.

Es besteht deshalb die Aufgabe, eine Fahrzeugleuchte der eingangs genannten Art zu schaffen, die auch bei hohen Umgebungstemperaturen eine ausreichend große Lichtstärke der Leuchtdiode(n) ermöglicht.

Die Lösung dieser Aufgabe besteht darin, daß die Wärmeableiteinrichtung zur Kühlung der Leuchtdiode(n) als aktive Temperiereinrichtung ausgebildet ist.

Die Leuchtdioden können dann auch bei hohen Umgebungstemperaturen wirkungsvoll gekühlt werden, wobei sogar eine Kühlung der Leuchtdioden bis auf eine Betriebstemperatur möglich ist, die kleiner ist als die Umgebungstemperatur. In vorteilhafter Weise können deshalb die Leuchtdioden auch bei hohen Umgebungstemperaturen, beispielsweise bei Temperaturen über 80 °C, mit einem vergleichsweise hohen Dauerbetriebsstrom bestromt werden, so daß sie eine entsprechend hohe Lichtstärke abgeben. Die Anzahl der Leuchtdioden kann somit bei gleicher Lichtstärke gegenüber einer konventionellen Fahrzeugleuchte mit passivem Kühlkörper erheblich reduziert sein, d.h. es können Leuchtdioden eingespart werden. Die erfindungsgemäße Fahrzeugleuchte ist deshalb kostengünstig herstellbar. Gegenüber einer konventionellen Fahrzeugleuchte mit passivem Kühlkörper kann außerdem die Absenkung des Betriebsstromes der Leuchtdioden bei hohen Umgebungstemperaturen reduziert und/oder zu höheren Temperaturen verschoben sein oder sogar ganz entfallen. Die Fahrzeugleuchte weist deshalb eine weitestgehend von der Umgebungstemperatur unabhängige, konstante Leuchtfarbe auf. In vorteilhafter Weise ergibt sich aufgrund der durch die aktive Temperiereinrichtung reduzierte Betriebstemperatur der Leuchtdioden aber auch eine längere Lebensdauer der Leuchtdioden und somit der gesamten Fahrzeugleuchte.

Besonders vorteilhaft ist, wenn die Temperiereinrichtung wenigstens ein Peltierelement mit einer Kühlseite und einer Heizseite aufweist, und wenn die Leuchtdiode(n) mit der Kühlseite des Peltierelements thermisch leitend verbunden ist (sind). Dadurch ergibt sich eine einfach aufgebaute, kompakte Temperiereinrichtung, die außerdem kostengünstig herstellbar ist. Gegebenenfalls können sogar mehrere Peltierelemente zu einem Stapel miteinander verbunden sein, wodurch eine noch effektivere Kühlung der Leuchtdiode(n) erreicht werden kann. Dabei ist jeweils bei zwei benachbart übereinander geschichteten Peltierelementen die Kühlseite des einen Peltierelements mit der Wärmeseite des anderen, dazu benachbarten Peltierelements verbunden.

Vorteilhaft ist, wenn die Temperiereinrichtung zur Regelung der Temperatur der Leuchtdiode(n) eine Temperatur-Regeleinrichtung mit einem Temperaturfühler aufweist. Die Betriebstemperatur der Leuchtdioden kann dann weitgehend unabhängig von der Umgebungstemperatur konstantgehalten oder auf eine vorgegebene Temperatur begrenzt werden. Bei niedrigen Umgebungstemperaturen kann die Temperiereinrichtung gegebenenfalls ganz abgeschaltet sein, wodurch bei einer ein Peltierelement aufweisenden Temperiereinrichtung die elektrische Energie zum Betreiben des Peltierelements eingespart werden kann.

Bei einer Ausführungsform der Erfindung ist (sind) die Leuchtdiode(n) mit einer Stromversorgungseinrichtung verbunden, die einen an einem Temperatursensor angeschlossenen Stromsteuereingang zum temperaturabhängigen Einstellen des Leuchtdioden-Betriebsstromes aufweist. Der Betriebsstrom kann dann oberhalb einer kritischen Temperatur abgesenkt werden. Die Fahrzeugleuchte kann dadurch bei noch höheren Umgebungstemperaturen im Dauerbetrieb betrieben werden, ohne daß die Leuchtdiode(n) thermisch geschädigt wird (werden). Außerdem werden die Leuchtdioden unmittelbar nach dem Einschalten des Peltierelements vor thermischer Überlastung geschützt, wenn die Kühlseite des Peltierelements ihre Betriebstemperatur noch nicht erreicht hat.

Vorteilhaft ist, wenn der Stromsteuereingang der Stromversorgungseinrichtung indirekt über einen Mikroprozessor mit dem Temperatursensor verbunden ist und wenn dem Mikroprozessor ein Datenspeicher zugeordnet ist, in welchem für unterschiedliche Temperaturmeßwerte des Temperatursensors jeweils ein Sollwert für den Leuchtdiodenstrom gespeichert ist. Dabei können die Temperaturmeßwerte und die diesem jeweils zugeordneten Leuchtdiodenströme beispielsweise in Form von Wertekombinationen oder in Form von Kennlinien in dem Datenspeicher abgelegt sein. Gegebenenfalls können für die einzelnen Leuchtdiodenstrom-Sollwerte jeweils sogar mehrere, ein zeitliches Temperaturprofil definierende Temperaturwerte gespeichert sein, so daß bei der Einstellung des Leuchtdiodenstromes eine zeitliche Veränderung der Temperatur der Leuchtdioden und/oder der Umgebung berücksichtigt werden kann. Die temperaturabhängige Einstellung des Leuchtdiodenstromes kann beispielsweise mittels eines mit einem Ausgang des Mikroprozessors verbundenen Transistors erfolgen.

Vorteilhaft ist, wenn mehrere jeweils als Halbleiterchip ausgebildeten Leuchtdioden in Hybridtechnik mit der Kühlseite des Peltierelements und/oder einer damit in wärmeleitenden Kontakt stehenden Leiterplatten verbunden sind. Die Fahrzeugleuchte ist dann besonders kostengünstig herstellbar. Dabei können gegebenenfalls noch weitere für den Betrieb oder die Ansteuerung der Leuchtdioden vorgesehene Schaltungsteile, wie zum Beispiel der Mikroprozessor, der Datenspeicher, wenigstens ein Leistungstransistor zur Einstellung des Leuchtdiodenstromes und/oder wenigstens ein Temperaturfühler in Hybridtechnik mit der Leiterplatte oder der Kühlseite des Peltierelements integriert sein.

Zweckmäßigerweise liegen die als Halbleiterchip ausgebildeten Leuchtdioden jeweils mit ihrer der Abstrahlseiten abgewandten Rückseite vorzugsweise plan an der Kühlseite des Peltierelements oder an der dem Peltierelement abgewandten Vorderseite einer rückseitig mit dem Peltierelement wärmeleitend verbundenen Leiterplatte an. Die Leuchtdioden können dann großflächig und somit besonders wirkungsvoll gekühlt werden.

Besonders vorteilhaft ist, wenn eine die Kühlseite und die Heizseite des Peltiertelements gegeneinander abgrenzende, thermische Isolation vorgesehen ist und wenn diese vorzugsweise durch ein die Kühlseite mit den Leuchtdioden umgrenzendes Leuchtengehäuse gebildet ist. Die Leuchtdioden sind dann im inneren des Leuchtengehäuses thermisch mit der Kühlseite des Peltierelements verbunden und durch die Wandung des Leuchtengehäuses gegen die Wärmeseite des Peltierelements thermisch isoliert. Die an den Leuchtdioden auftretende Verlustwärme kann dann noch besser von den Leuchtdioden abgeführt werden. Die den Leuchtdioden zugewandte Wandung des Leuchtengehäuses kann eine Lichtscheibe und/oder optische Elemente, wie zum Beispiel Streulinsen, aufweisen.

Vorteilhaft ist, wenn die Fahrzeugleuchte Anschlußstellen zum thermisch leitenden Verbinden der Heizseite des Peltierelements mit einer Fahrzeugkarosserie aufweist. Die an der Heizseite des Peltierelements abgegebene Wärme kann dann in ein thermisch gut leitendes Teil der Fahrzeugkarosserie, beispielsweise ein Blechteil abgeleitet werden. Die Außenkontur der Fahrzeugleuchte kann an der Verbindungsstelle an die Fahrzeugkarosserie formangepaßt sein, um eine großflächige Wärmeeinleitung in die Fahrzeugkarosserie zu ermöglichen.

Nachfolgend ist ein Ausführungsbeispiel der Erfindung anhand der Zeichnung näher erläuert. Es zeigen zum Teil stärker schematisiert:
- Fig. 1: eine Aufsicht auf die Kühlseite eines Peltierelements einer Fahrzeugleuchte, wobei die an der Kühlseite matrixförmig angeordneten Leuchtdioden besonders gut erkennbar sind, und wobei das Layout der Leiterbahnen vereinfacht dargestellt ist
- Fig. 2: eine Seitenansicht der in Fig. 1 gezeigten Fahrzeugleuchte und
- Fig. 3: einen Querschnitt durch die an einer Fahrzeugkarosserie montierte Fahrzeugleuchte gemäß Fig. 1, wobei die Fahrzeugkarosserie nur teilweise dargestellt ist.

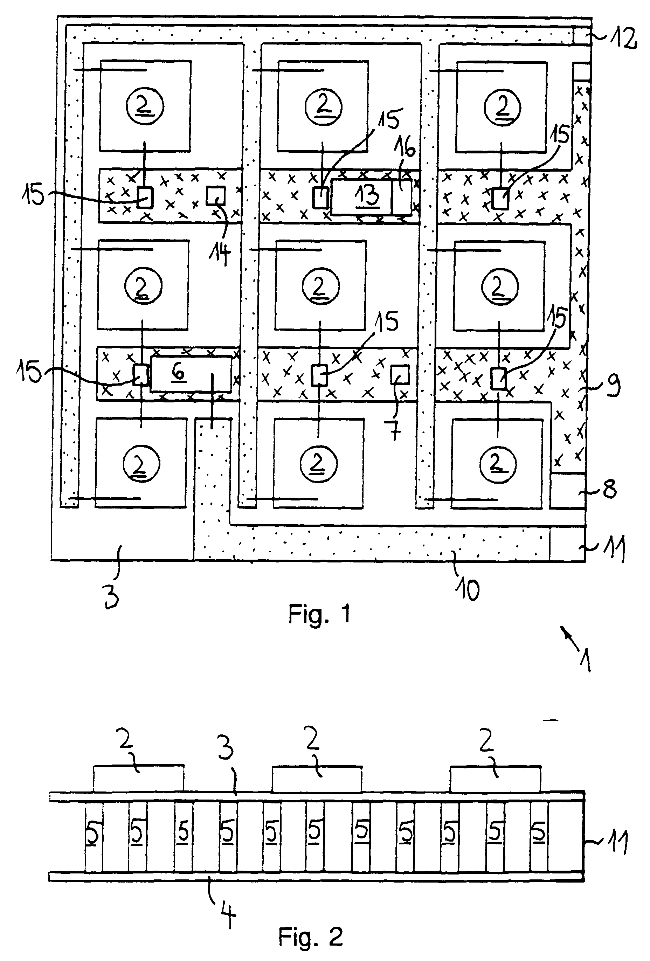

Eine im ganzen mit 1 bezeichnete Fahrzeugleuchte weist als Lichtquellen mehrere Leuchtdioden 2 auf, die jeweils mit der Kühlseite 3 eines eine Kühlseite 3 und einer Heizseite 4 aufweisenden Peltierelement thermisch leitend verbunden sind. In Fig. 1 ist erkennbar, daß die Leuchtdioden 2 matrixförmig in mehreren Reihen und Spalten an der Kühlseite 3 des Peltierelements angeordnet sind.

Die Kühlseite 3 und die Heizseite 4 des Peltierelements sind jeweils plattenförmig ausgebildet und bestehen aus einem thermisch gut leitenden und elektrisch isolierenden Material, zum Beispiel aus Keramik. In Fig. 2 ist erkennbar, daß die Kühlseite 3 und die Heizseite 4 etwa parallel zueinander angeordnet sind.

Zwischen der Kühlseite 3 und der Heizseite 4 sind eine Vielzahl von Halbleiterelementen in mehreren Reihen und Spalten nebeneinander angeordnet, die jeweils eine Peltierzelle 5 bilden. Die einzelnen Peltierzellen 5 sind jeweils mit ihrem kalten Ende mit der den Leuchtdioden 2 abgewandten Rückseite der Kühlseite 3 und mit ihrem warmen Ende mit der der Kühlseite 3 zugewandten Rückseite der Heizseite 4 thermisch leitend verbunden.

Die Kühlseite 3 und die Heizseite 4 weisen jeweils an ihren einander zugewandten Flachseiten Leiterbahnen auf, die als Stromzufuhr für die Peltierzellen 5 dienen. Das Peltierelement ermöglicht eine wirkungsvolle Kühlung der Leuchtdioden 2, so daß diese auch bei hohen Umgebungstemperaturen mit einem vergleichsweise großen Dauer-Betriebsstrom bestromt werden können, ohne thermisch Schaden zu nehmen. Die Leuchtdioden 2 leuchten dadurch auch bei hohen Umgebungstemperaturen, beispielsweise bei Umgebungstemperaturen von über 80° Celcius mit großer Lichtstärke, so daß zum Erreichen einer vorgegebenen Gesamtlichtstärke der Fahrzeugleuchte nur eine entsprechend kleine Anzahl Leuchtdioden 2 erforderlich ist.

Zur Regelung der Temperatur der Leuchtdioden 2 ist eine Temperatur-Regeleinrichtung 6 mit einem mit der Kühlseite 3 des Peltierelements thermisch leitend verbundene Temperaturfühler 7 vorgesehen. Die Temperatur-Regeleinrichtung 6 hat einen Leistungstransistor, der die Peltierzellen 5 mit dem Anschluß 8 für den positiven Pol einer Gleichstromversorgung verbindet. Die an der Kühlseite 3 des Peltierelements angeordnete Temperatur-Regeleinrichtung ist dazu über eine erste Leiterbahn 9 mit dem Anschluß 8 für den Pluspol und über eine zweite Leiterbahn 10 sowie eine die Kühlseite 3 mit der Heizseite 4 verbindende Brücke 11 an einem ersten Stromversorgungsanschluß des Peltierelements angeschlossen. Der andere Stromversorgungsanschluß des Peltierelements ist mit einem Anschluß 12 für den negativen Pol der Gleichstromversorgung verbunden.

Oberhalb einer vorgegebenen Temperatur wird der Betriebsstrom des Peltierelements zum Regeln der Temperatur der Leuchtdioden 2 mittels der Temperatur-Regeleinrichtung 6 eingestellt. Unterhalb dieser vorgegebenen Temperatur ist eine Kühlung der Leuchtdioden 2 mittels des Peltierelements nicht erforderlich und das Peltierelement ist dann abgeschaltet. Der Anschluß 8 ist über den Zündschalter des Fahrzeugs, in welches die Fahrzeugleuchte 1 eingebaut ist, mit der Gleichstromversorgung des Fahrzeugs verbunden, derart, daß die Temperatur-Regeleinrichtung 6 und das Peltierelement nur bei eingeschalteter Fahrzeugzündung aktiviert sind. Bei abgeschalteter Fahrzeugzündung ist der Stromkreis von der Gleichstromversorgung zum Peltierelement unterbrochen.

Damit insbesondere nach dem Einschalten der Zündung beziehungsweise der Stromversorgung des Fahrzeugs die bei hohen Umgebungstemperaturen zunächst noch heißen Leuchtdioden 2 nicht mit einem zu großen Betriebsstrom bestromt und somit thermisch überlastet werden, wird der Betriebsstrom der Leuchtdioden 2 mittels eines Mikroprozessors 13 in Abhängigkeit von der Temperatur der Kühlseite 3 des Peltierelements auf einen vorgegebenen Wert begrenzt. Der Mikroprozessor 13 ist dazu einerseits mit einem Temperatursensor 14 und andererseits mit Stellelementen 15 zum Einstellen des Leuchtdiodenstroms verbunden. Wie in Fig. 1 erkennbar ist, ist jeder Leuchtdiode 2 jeweils ein eigenes Stellelement 15 zugeordnet, das beispielsweise einen mit der Leuchtdiode 2 in Reihe geschalteten Transistor aufweisen kann.

Der Mikroprozessor 13 ist mit einem Datenspeicher 16 verbunden, in welchem für unterschiedliche Temperaturmeßwerte des Temperatursensors 14 jeweils ein Sollwert für den Leuchtdiodenstrom gespeichert ist. Mittels des Temperatursensors 14 werden jeweils Ist-Werte für die Temperatur der Kühlseite 3 des Peltierelements erfaßt und in den Mikroprozessor 13 eingelesen. Anhand der in dem Datenspeicher 16 abgelegten Kenngrößen wird den Temperatur-Ist-Werten jeweils ein Soll-Wert für den Leuchtdiodenstrom zugeordnet, der durch entsprechendes Ansteuern der Stellelemente 15 eingestellt wird.

Beim Einschalten des Zündschalters des Fahrzeugs wird der Stromkreis des Peltierelements geschlossen, sofern die Temperatur an der Kühlseite 3 einen vorgegebenen Temperatur-Grenzwert, der beispielsweise 60° Celcius betragen kann und durch die Temperaturbelastbarkeit der Leuchtdioden 2 vorgegeben ist, überschreitet. Die Temperatur an der Kühlseite 3 nimmt dann ausgehend von der beim Einschalten des Zündschalters vorhandenen Anfangstemperatur kontinuierlich ab, bis der vorgegebene Temperaturgrenzwert erreicht wird. Sollte die Kühlleistung des Peltierelements bei hohen Umgebungstemperaturen nicht ausreichen, um die Kühlseite 3 auf dem vorgegebenen Temperatur-Grenzwert abzukühlen, wird das Peltierelement mit dem maximalen Betriebsstrom bestromt. An der Kühlseite 3 stellt sich dann nach einiger Zeit eine gegenüber der Umgebungstemperatur geringere Temperatur ein.

Während der Abkühlphase werden die Leuchtdioden 2 in Abhängigkeit von der jeweiligen Temperatur an der Kühlseite 3 bestromt. Dabei nimmt der Leuchtdiodenstrom zu, bis die Temperatur an der Kühlseite 3 den vorgegebenen Temperaturgrenzwert erreicht hat. Unterhalb des Temperatur-Grenzwerts werden die Leuchtdioden 2 mit einem konstanten, von der Temperatur unabhängigen Leuchtdiodenstrom betrieben.

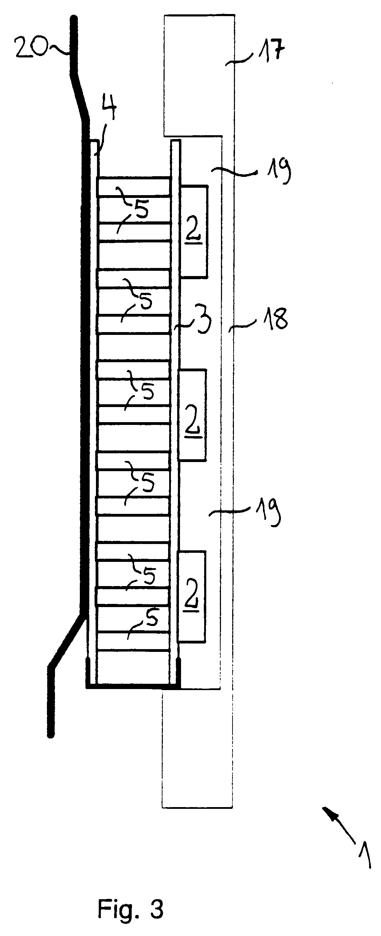

In Fig. 1 und 3 ist erkennbar, daß an der Kühlseite 3 des Peltierelements eine Vielzahl von Leuchtdioden 2 matrixförmig nebeneinander angeordnet sind. Die Leuchtdioden 2 sind als SMD-Bauteile ausgebildet, die jeweils an ihrer der Abstrahlseite abgewandten Rückseite plan an der Oberfläche der Kühlseite 3 anliegen. Dadurch ergibt sich eine großflächige, thermisch gut leitende Verbindung zwischen den Leuchtdioden 2 und der Kühlseite 3. Erwähnt werden soll nach, daß die in Hybridtechnik ausgebildete Kühlseite 3 weitere, in der Zeichnung nicht dargestellte Bauelemente aufweisen kann.

An der Kühlseite 3 ist ein Leuchtengehäuse 17 mit einer transparenten Lichtscheibe 18 angeordnet, welche die Leuchtdioden 2 überdeckt. Das Leuchtengehäuse 17 weist eine Innenhöhlung 19 auf, in der die Leuchtdioden 2 zwischen der Kühlseite 3 und der Lichtscheibe 18 angeordnet sind. Der die Innenhöhlung 19 seitlich umgrenzende Rand des Leuchtengehäuses 17 ist mit der Kühlseite 3 des Peltierelements dicht verbunden. Durch das Leuchtengehäuse 17 ist die die Leuchtdioden 2 aufweisende Vorderseite der Kühlseite 3 des Peltierelements thermisch gegen dessen Heizseite 4 isoliert. Die Leuchtdioden 2 sind in der Innenhöhlung 19 mit Abstand zu den Gehäusewänden des Leuchtengehäuses 17 angeordnet. Die Innenhöhlung 19 kann beispielsweise evakuiert oder zum Beispiel mit Luft oder einem anderen thermisch isolierenden Gas gefüllt sein.

In Fig. 3 ist erkennbar, daß die Fahrzeugleuchte 1 an der Heizseite 4 des Peltierelements eine mit dem Blech der Fahrzeugkarosserie 20 verbundene Anschlußstelle aufweist. Deutlich ist erkennbar, daß die Heizseite 4 plan an dem Blech der Fahrzeugkarosserie 20 anliegt. Somit kann die an der Heizseite 3 abgegebene Wärme in die Fahrzeugkarosserie 20 und von dort an die Umgebung abgeleitet werden.

## Patentansprüche

1. Fahrzeugleuchte (1), insbesondere Signalleuchte, mit wenigstens einer Leuchtdiode (2) als Lichtquelle, die mit einer Wärmeableiteinrichtung thermisch leitend verbunden ist, **dadurch gekennzeichnet**, daß die Wärmeableiteinrichtung zur Kühlung der Leuchtdiode(n) (2) als aktive Temperiereinrichtung ausgebildet ist.

2. Fahrzeugleuchte (1) nach Anspruch 1, dadurch gekennzeichnet, daß die Temperiereinrichtung wenigstens ein Peltierelement mit einer Kühlseite (3) und einer Heizseite (4) aufweist, und daß die Leuchtdiode(n) (2) mit der Kühlseite (3) des Peltierelements thermisch leitend verbunden ist (sind).

3. Fahrzeugleuchte (1) nach Anspruch 1 oder 2, dadurch gekennzeichnet, daß die Temperiereinrichtung zur Regelung der Temperatur der Leuchtdiode(n) (2) eine Temperatur-Regeleinrichtung (6) mit einem Temperaturfühler (7) aufweist.

4. Fahrzeugleuchte (1) nach einem der Ansprüche 1 bis 3, dadurch gekennzeichnet, daß die Leuchtdiode(n) (2) mit einer Stromversorgungseinrichtung verbunden ist (sind), die einen an einem Temperatursensor (14) angeschlossenen Stromsteuereingang zum temparaturabhängigen Einstellen des Leuchtdioden-Betriebsstromes aufweist.

5. Fahrzeugleuchte (1) nach einem der Ansprüche 1 bis 4, dadurch gekennzeichnet, daß der Stromsteuereingang der Stromversorgungseinrichtung indirekt über ein Mikroprozessor (13) mit dem Temperatursensor (14) verbunden ist und daß dem Mikroprozessor (13) ein Datenspeicher (16) zugeordnet ist, in dem für unterschiedliche Temperaturmweßwerte des Temperatursensors (14) jeweils ein Sollwert für den Leuchtdiodenstrom gespeichert ist.

6. Fahrzeugleuchte (1) nach einem der Ansprüche 1 bis 5, dadurch gekennzeichnet, daß an de Kühlseite (3) eine Vielzahl von Leuchtdioden (2) vorzugsweise matrixförmig nebeneinander angeordnet sind.

7. Fahrzeugleuchte (1) nach einem der Ansprüche 1 bis 6, dadurch gekennzeichnet, daß mehrere jeweils als Halbleiterchip ausgebildete Leuchtdioden (2) in Hybridtechnik mit der Kühlseite (3) des Peltierelements und/oder einer damit in wärmeleitendem Kontakt stehenden, elektrischen Leiterplatte verbunden sind.

8. Fahrzeugleuchte (1) nach einem der Ansprüche 1 bis 7, dadurch gekennzeichnet, daß die als Halbleiterchip ausgebildeten Leuchtdioden (2) jeweils mit ihrer der Abstrahlseite abgewandten Rückseite vorzugsweise plan an der Kühlseite (3) des Peltierelements oder an der dem Peltierelement abgewandten Vorderseite einer rückseitig mit dem Peltierelement wärmeleitend verbundenen Leiterplatte anliegt.

9. Fahrzeugleuchte (1) nach einem der Ansprüche 1 bis 8, dadurch gekennzeichnet, daß eine die Kühlseite (3) und die Heizseite (4) des Peltierelements gegeneinander abgrenzende, thermische Isolation vorgesehen ist und daß diese vorzugsweise durch ein die Kühlseite (3) mit den Leuchtdioden (2) umgrenzendes Leuchtengehäuse (17) gebildet ist.

10. Fahrzeugleuchte (1) nach einem der Ansprüche 1 bis 9, dadurch gekennzeichnet, daß sie Anschlußstellen zum thermisch leitenden Verbinden der Heizseite (4) des Peltierelements mit einer Fahrzeugkarrossie (20) aufweist.
